# EUROPEAN PATENT APPLICATION

(11) **EP 4 556 591 A1**
(43) Date of publication of application: **21.05.2025**
(21) Application number: 23213114.4
(22) Date of filing: 29.11.2023
(51) Int. Cl.: C23C 6/00, C23C 14/00, C23C 14/06, C23C 14/18, C23C 14/35, C23C 14/58, C23C 28/00, H01M 4/04, H01M 4/1395, H01M 4/38, H01M 4/58, H01M 4/62, H01M 10/052, H01M 10/0562

(54) **LITHIUM SECONDARY BATTERY AND PREPARATION METHOD THEREFOR**

(30) Priority: 14.11.2023 CN 202311510718
(71) Applicant: Shenzhen Huineng Energy Storage Materials Engineering Research Center Co., Ltd, Shenzhen City 518000 (CN); National Engineering Research Center of Advanced Energy Storage Materials (Shenzhen) Co., Ltd, Shenzhen, Guangdong 518000 (CN)
(72) Inventor: Faping, ZHONG, Shenzhen City, 518000 (CN); Chihuan, HE, Shenzhen City, 518000 (CN); Subin, JIANG, Shenzhen City, 518000 (CN); Hongbing, LIU, Shenzhen City, 518000 (CN); Jiqun, ZHU, Shenzhen City, 518000 (CN); Shuifa, TAN, Shenzhen City, 518000 (CN)
(74) Representative: AWA Sweden AB

(57) **Abstract**

The present invention provides a lithium secondary battery and a preparation method therefor. According to the method, a LiPON thin film layer and a Li₃PO₄ thin film layer are separately deposited on two surfaces of a sulfide solid electrolyte layer by magnetron sputtering; afterwards, a positive electrode raw material (Li3PO₄, Fe₂O₃, and carbon) composite material layer is deposited on a surface of the Li₃PO₄ thin film layer; the composite material layer is transformed into a positive active material layer after high-temperature sintering; a current collector layer is sputtered and deposited on a surface of the positive active material layer; the LiPON is dropwise coated with molten metal lithium; and the lithium secondary battery is obtained after pressing and packaging. The all-solid-state lithium secondary battery prepared by the present invention has excellent rate performance and cycle performance.

## Description

### TECHNICAL FIELD

The present invention relates to the technical field of electrochemical energy storage, and in particular, to a lithium secondary battery and a preparation method therefor.

### BACKGROUND

Lithium secondary batteries are widely used as power sources for portable electronic devices, power tools, and the like thanks to advantages such as high energy density and long life. Recently, the lithium secondary batteries are also applied to large batteries mounted in Electric Vehicles (EV), Hybrid Electric Vehicles (HEV), and the like. However, a conventional lithium battery adopts a flammable and explosive organic electrolyte solution. If the battery has a short circuit in charging and discharging processes, fire is easily caused, which brings harm to the personal safety and the property safety of consumers. Therefore, a nonflammable solid electrolyte is used to replace the organic electrolyte solution to develop an all-solid-state lithium ion battery, which is expected to fundamentally solve the above safety problems.

A sulfide solid electrolyte is considered to be one of the most commercially viable solid electrolytes because of its advantages of high ionic conductivity, good mechanical ductility, and good interfacial contact with electrodes.

However, the sulfide solid electrolyte itself has some disadvantages, which restrict its widespread use. First, this type of material is sensitive to wet air and easily reacts with water to generate H₂S. Secondly, the sulfide solid electrolyte and a lithium negative electrode have poor stability and are easy to reduce. In addition, the electrode is in solid-solid contact with the sulfide electrolyte, so that the interfacial contact resistance is higher than the interfacial contact resistance of solid-liquid contact. Meanwhile, the interfacial compatibility and stability would also obviously affect the cycle performance and rate performance of the all-solid-state lithium battery.

### SUMMARY

Based on this, in order to solve the above technical problems, the present invention provides a lithium secondary battery and a preparation method therefor. The method includes the following steps in sequence:
(1) carrying out magnetron sputtering in a nitrogen atmosphere by using a sulfide solid electrolyte layer as a base material and using Li₃PO₄ as a target material, to sputter a LiPON thin film layer on one surface of the base material;
(2) vacuumizing a magnetron sputtering chamber, then introducing argon, and sputtering a Li₃PO₄ thin film layer on the other surface of the base material by using the Li₃PO₄ as the target material;
(3) maintaining an argon atmosphere, simultaneously co-sputtering three target materials: a Li₃PO₄ target, a Fe₂O₃ target, and a carbon target, and depositing a composite material layer on the Li₃PO₄ thin film layer to obtain a multilayer material with the composite material layer/Li₃PO₄ thin film layer/sulfide solid electrolyte layer/LiPON thin film layer;
(4) transferring the multilayer material into sintering equipment, and carrying out high-temperature calcination in the argon atmosphere to transform the composite material layer into a positive active material layer through a high-temperature solid-phase reaction;
(5) carrying out magnetron sputtering on the material subjected to the high-temperature calcination by using an aluminum target, to sputter and deposit an aluminum current collector layer on a surface of the positive active material layer;
(6) uniformly dropwise coating a surface of the LiPON thin film layer with molten metal lithium under an argon protection atmosphere, applying a pressure after cooling to flatten a metal lithium layer, and compressing a battery core; and
(7) packaging the battery core in a battery shell to obtain the lithium secondary battery.

Further, the purity of the target material is greater than or equal to 99.9%.

Further, a sulfide solid electrolyte in step (1) is one or more of Li₂S-P₂S₅, Li₁₀GeP₂S₁₂, Li₇P₂S₈X, and Li₆PS₅X, and X is one or more of Cl, Br, and I; and the sulfide solid electrolyte layer is prepared by tabletting sulfide solid electrolyte powder.

Further, the LiPON thin film layer in step (1) has a thickness of 5 to 10 □m.

Further, the Li₃PO₄ thin film layer in step (2) has a thickness of 0.1 to 1 □m.

Further, the composite material layer in step (3) has a thickness of 5 to 10 □□m.

Further, the high-temperature calcination in step (4) is two-stage sintering; in the first stage of sintering, a heating rate is 3 to 5 °C/min, a sintering temperature is 350 to 450°C, and the temperature is kept for 3 to 6 h; and in the second stage of sintering, a heating rate is 5 to 10 °C/min, a sintering temperature is 650 to 900°C, and the temperature is kept for 6 to 18 h.

Further, the aluminum current collector layer in step (5) has a thickness of 1 to 10 □m. Further, the metal lithium layer in step (6) has a thickness of 1 to 5 □m; and the applying a pressure is performed by applying a pressure of 5 to 10 MPa to one side of the metal lithium layer using a polyimide plate.

Another objective of the present invention is to provide a lithium secondary battery, wherein the lithium secondary battery is prepared by the preparation method according to any one of claims 1 to 9.

The present invention has the following beneficial effects:
(1) According to the present invention, the Li₃PO₄ thin film layer is deposited in advance on the surface of one side, facing a positive electrode, of the sulfide solid electrolyte layer through magnetron sputtering. The thin film layer is used as a protective layer for the sulfide solid electrolyte layer and is the same as one of raw materials of a positive active material LiFePO₄ generated in a high-temperature solid phase stage, so that a C@LiFePO₄ active material layer generated in by a high-temperature solid phase can be induced to be tightly combined with the thin film layer deposited in advance, and a solid-solid interface between the electrode and the solid electrolyte is improved.
(2) According to the present invention, the LiPON thin film layer is deposited in advance on a surface of one side, facing a negative electrode, of the sulfide solid electrolyte layer through magnetron sputtering. The LiPON thin film layer can play a role in protecting the sulfide solid electrolyte layer to avoid the reduction effect of lithium metal on the sulfide solid electrolyte. Furthermore, the LiPON thin film layer reacts with the molten metal lithium dropwise coated on the surface of the LiPON thin film layer, and the Li₃N generated can modify the surface of the metal lithium, so that formation of lithium dendrites is avoided.
(3) According to the present invention, the LiPON thin film layer and the Li₃PO₄ thin film layer are separately deposited on the two surfaces of the sulfide solid electrolyte layer through the magnetron sputtering, and the two deposited functional layers use the same raw material Li₃PO₄ target material. The deposition of different functional layers can be achieved by switching magnetron sputtering atmospheres, so that the technological process is simplified, and the economic efficiency is better.
(4) According to the high-temperature sintering step of the present invention, the composite material layer of the positive raw material obtained by sputtering can be transformed into the positive active material layer, and the sulfide solid electrolyte layer obtained by pressing can be more compact. A stepwise sintering treatment measure is adopted in the sintering process, so that it is more favorable for implementing the process.
(5) The lithium secondary battery prepared by the present invention has better solid-solid interfacial compatibility and stability, and can obviously improve the rate performance and cycle performance of the all-solid-state lithium secondary battery.

### BRIEF DESCRIPTION OF THE DRAWINGS

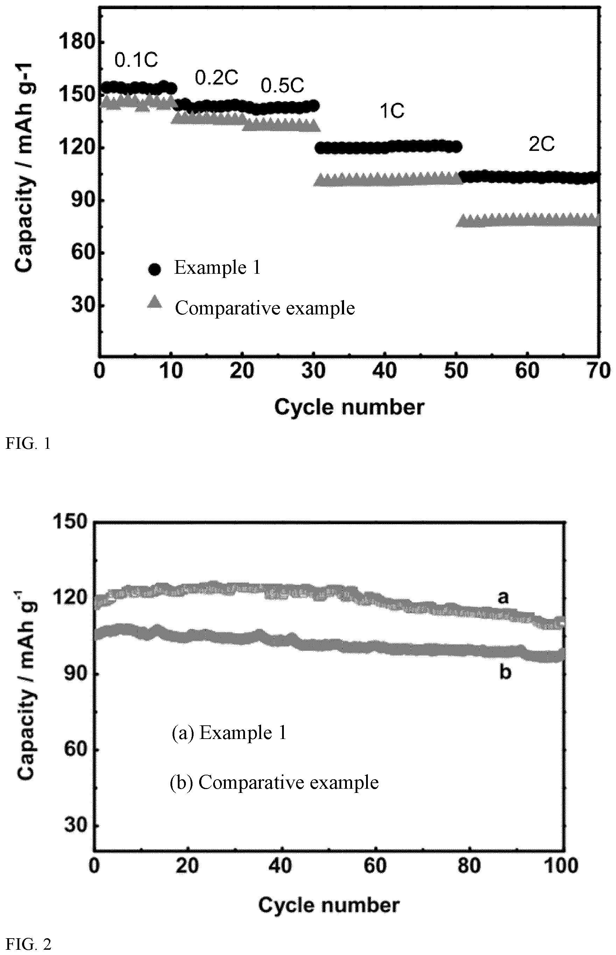

FIG. 1 shows a diagram of rate performance of batteries of Example 1 and Comparative example
FIG. 2 shows a diagram of cycle performance of batteries of Example 1 and Comparative example

### DETAILED DESCRIPTION

The present invention will be further described below with reference to examples and comparative examples.

### Example 1

A sulfide Li₂S-P₂S₅ solid electrolyte film was used as a base material; the Li₂S-P₂S₅ solid electrolyte film was prepared by tabletting Li₂S-P₂S₅ powder; Li₃PO₄ with the purity greater than or equal to 99.9% was used as a target material; magnetron sputtering was carried out in a nitrogen atmosphere; a distance between the magnetron sputtering target material and the base material was 5 cm; power of the magnetron sputtering was 10 W/cm²; a LiPON thin film layer with a thickness of 5 □m was sputtered on one surface of the base material; a magnetron sputtering chamber was vacuumized until a pressure was less than 1×10⁻⁴ Pa; afterwards, argon was introduced; Li₃PO₄ with the purity greater than or equal to 99.9% was used as a target material; a Li₃PO₄ thin film layer with a thickness of 1 □m was continuously sputtered on the other surface of the base material;
an argon atmosphere was maintained; three target materials, such as a Li₃PO₄ target, a Fe₂O₃ target, and a carbon target, with the purities greater than or equal to 99.9% were used; the three target materials were simultaneously co-sputtered at powers of 5 W/cm², 5 W/cm², and 10 W/cm² respectively; a composite material layer with a thickness of 5 □m was sputtered on the Li₃PO₄ thin film layer to obtain a multilayer material with the composite material layer/Li₃PO₄ thin film layer/sulfide solid electrolyte layer/LiPON thin film layer; the multilayer material was then transferred into a muffle furnace; high-temperature calcination was carried out in the argon atmosphere; the temperature was heated to 350°C at a heating rate of 5 °C/min and was maintained for 6 h; the temperature was then heated to 900 °C at a heating rate of 10 °C/min and was maintained for 6 h; the composite material layer was transformed into a positive active material layer through a high-temperature solid-phase reaction; afterwards, the multilayer material was fixed in a magnetron sputtering chamber, and magnetron sputtering was carried out by using an aluminum target at power of 10 W/cm², so that an aluminum current collector layer with a thickness of 5 □m was sputtered and deposited on a surface of the positive active material layer;
finally, the material described above was placed in a glove box filled with argon; a surface of the LiPON thin film layer was uniformly dropwise coated with molten metal lithium; a pressure of 5 MPa was applied after cooling to flatten a metal lithium layer; the flattened metal lithium layer had a thickness of 2 □□m; a battery core was compressed; and the multilayer material of the battery core was packaged in a battery shell, so that a lithium secondary battery in Example 1 was obtained.

### Example 2

A sulfide Li₁₀GeP₂S₁₂ solid electrolyte film was used as a base material; the Li₁₀GeP₂S₁₂ solid electrolyte film was prepared by tabletting Li₁₀GeP₂S₁₂ powder; Li₃PO₄ with the purity greater than or equal to 99.9% was used as a target material; magnetron sputtering was carried out in a nitrogen atmosphere; a distance between the magnetron sputtering target material and the base material was 5 cm; power of the magnetron sputtering was 10 W/cm²; a LiPON thin film layer with a thickness of 10 □m was sputtered on one surface of the base material; a magnetron sputtering chamber was vacuumized until a pressure was less than 1×10⁻⁴ Pa; afterwards, argon was introduced; Li₃PO₄ with the purity greater than or equal to 99.9% was used as a target material; a Li₃PO₄ thin film layer with a thickness of 0.5 □m was continuously sputtered on the other surface of the base material;
an argon atmosphere was maintained; three target materials, such as a Li₃PO₄ target, a Fe₂O₃ target, and a carbon target, with the purities greater than or equal to 99.9% were used; the three target materials were simultaneously co-sputtered at powers of 5 W/cm², 5 W/cm², and 10 W/cm² respectively; a composite material layer with a thickness of 10 □m was sputtered on the Li₃PO₄ thin film layer to obtain a multilayer material with the composite material layer/Li₃PO₄ thin film layer/sulfide solid electrolyte layer/LiPON thin film layer; the multilayer material was then transferred into a muffle furnace; high-temperature calcination was carried out in the argon atmosphere; the temperature was heated to 450°C at a heating rate of 5 °C/min and was maintained for 3 h; the temperature was then heated to 650°C at a heating rate of 5°C/min and was maintained for 18 h; the composite material layer was transformed into a positive active material layer through a high-temperature solid-phase reaction; afterwards, the multilayer material was fixed in a magnetron sputtering chamber, and magnetron sputtering was carried out by using an aluminum target at power of 10 W/cm², so that an aluminum current collector layer with a thickness of 1 □m was sputtered and deposited on a surface of the positive active material layer;
finally, the material described above was placed in a glove box filled with argon; a surface of the LiPON thin film layer was uniformly dropwise coated with molten metal lithium; a pressure of 10 MPa was applied after cooling to flatten a metal lithium layer; the flattened metal lithium layer had a thickness of 1 □□m; a battery core was compressed; and the multilayer material of the battery core was packaged in a battery shell, so that a lithium secondary battery in Example 2 was obtained.

### Example 3

A sulfide Li₆PS₅Cl solid electrolyte film was used as a base material; the Li₆PS₅Cl solid electrolyte film was prepared by tabletting Li₆PS₅Cl powder; Li₃PO₄ with the purity greater than or equal to 99.9% was used as a target material; magnetron sputtering was carried out in a nitrogen atmosphere; a distance between the magnetron sputtering target material and the base material was 5 cm; power of the magnetron sputtering was 10 W/cm²; a LiPON thin film layer with a thickness of 8 □m was sputtered on one surface of the base material; a magnetron sputtering chamber was vacuumized until a pressure was less than 1×10⁻⁴ Pa; afterwards, argon was introduced; Li₃PO₄ with the purity greater than or equal to 99.9% was used as a target material; a Li₃PO₄ thin film layer with a thickness of 0.1 □m was continuously sputtered on the other surface of the base material;
an argon atmosphere was maintained; three target materials, such as a Li₃PO₄ target, a Fe₂O₃ target, and a carbon target, with the purities greater than or equal to 99.9% were used; the three target materials were simultaneously co-sputtered at powers of 5 W/cm², 5 W/cm², and 10 W/cm² respectively; a composite material layer with a thickness of 10 □m was sputtered on the Li₃PO₄ thin film layer to obtain a multilayer material with the composite material layer/Li₃PO₄ thin film layer/sulfide solid electrolyte layer/LiPON thin film layer; the multilayer material was then transferred into a muffle furnace; high-temperature calcination was carried out in the argon atmosphere; the temperature was heated to 350°C at a heating rate of 3°C/min and was maintained for 6 h; the temperature was then heated to 750°C at a heating rate of 5°C/min and was maintained for 12 h; the composite material layer was transformed into a positive active material layer through a high-temperature solid-phase reaction; afterwards, the multilayer material was fixed in a magnetron sputtering chamber, and magnetron sputtering was carried out by using an aluminum target at power of 10 W/cm², so that an aluminum current collector layer with a thickness of 10 □m was sputtered and deposited on a surface of the positive active material layer;
finally, the material described above was placed in a glove box filled with argon; a surface of the LiPON thin film layer was uniformly dropwise coated with molten metal lithium; a pressure of 5 MPa was applied after cooling to flatten a metal lithium layer; the flattened metal lithium layer had a thickness of 5 □□m; a battery core was compressed; and the multilayer material of the battery core was packaged in a battery shell, so that a lithium secondary battery in Example 3 was obtained.

### Comparative example

A sulfide Li₂S-P₂S₅ solid electrolyte film was used as a base material; the Li₂S-P₂S₅ solid electrolyte film was prepared by tabletting Li₂S-P₂S₅ powder; three target materials, such as a Li₃PO₄ target, a Fe₂O₃ target, and a carbon target, with the purities greater than or equal to 99.9% were used; the three target materials were simultaneously co-sputtered at powers of 5 W/cm², 5 W/cm², and 10 W/cm² respectively; a composite material layer with a thickness of 5 □m was deposited on one surface of the Li₂S-P₂S₅ solid electrolyte film to obtain a double-layer material with the composite material layer/sulfide solid electrolyte layer; the double-layer material was then transferred into a muffle furnace; high-temperature calcination was carried out in the argon atmosphere; the temperature was heated to 350°C at a heating rate of 5 °C/min and was maintained for 6 h; the temperature was then heated to 900 °C at a heating rate of 10 °C/min and was maintained for 6 h; the composite material layer was transformed into a positive active material layer through a high-temperature solid-phase reaction; afterwards, the double-layer material was fixed in a magnetron sputtering chamber, and magnetron sputtering was carried out by using an aluminum target at power of 10 W/cm², so that an aluminum current collector layer with a thickness of 5 □m was sputtered and deposited on a surface of the positive active material layer;
finally, the material described above was placed in a glove box filled with argon; the other surface of the Li₂S-P₂S₅ solid electrolyte film was uniformly dropwise coated with molten metal lithium; a pressure of 5 MPa was applied after cooling to flatten a metal lithium layer; the flattened metal lithium layer had a thickness of 2 □□m; a battery core was compressed; and the multilayer material of the battery core was packaged in a battery shell, so that a lithium secondary battery in Comparative example was obtained.

### Experiment and test on a battery

Charge and discharge cut-off voltages of the lithium secondary batteries were 2.5 to 4.2 V. A constant current was used for charging and discharging. An activation current was 0.1 C. A current for a charge and discharge cycle test was 1 C; and currents for a rate test were 0.1 C, 0.2 C, 0.5 C, 1 C, and 2 C.

The test results are shown in Table 1 and Table 2 below:

**Table 1**

| | 0.1 C | 0.2 C | 0.5 C | 1C | 2C |
|---|---|---|---|---|---|
| Example 1 (mAh·g⁻¹) | 154.6 | 147.8 | 147.1 | 119.7 | 104.3 |
| Example 2 (mAh·g⁻¹) | 156.4 | 149.2 | 137.4 | 118.5 | 102.4 |
| Example 3 (mAh·g⁻¹) | 152.2 | 144.7 | 128.5 | 113.7 | 100.3 |
| Comparative example (mAh·g⁻¹) | 146.2 | 137.6 | 133.4 | 101.5 | 85.4 |

**Table 2**

| | Example 1 | Example 2 | Example 3 | Comparative example |
|---|---|---|---|---|
| Specific capacity after 100 cycles (mAh·g⁻¹) | 109.3 | 104.9 | 105.1 | 93.5 |

As can be seen from the rate performance test results and the cycle performance test results, the lithium secondary batteries according to the examples of the present invention have higher rate performance and cycle performance than those of the battery of the Comparative example in which the Li₃PO₄ layer and the LiPON layer are not deposited on the surfaces of the sulfide solid electrolyte layer in advance. This is because the interfacial compatibility and stability of the lithium secondary batteries of the examples are higher than those of the battery of Comparative example.

## Claims

1. A preparation method for a lithium secondary battery, comprising the following steps in sequence:
(1) carrying out magnetron sputtering in a nitrogen atmosphere by using a sulfide solid electrolyte layer as a base material and using Li₃PO₄ as a target material, to sputter a LiPON thin film layer on one surface of the base material;
(2) vacuumizing a magnetron sputtering chamber, then introducing argon, and sputtering a Li₃PO₄ thin film layer on the other surface of the base material by using the Li₃PO₄ as the target material;
(3) maintaining an argon atmosphere, simultaneously co-sputtering three target materials: a Li₃PO₄ target, a Fe₂O₃ target, and a carbon target, and depositing a composite material layer on the Li₃PO₄ thin film layer to obtain a multilayer material with the composite material layer/Li₃PO₄ thin film layer/sulfide solid electrolyte layer/LiPON thin film layer;
(4) transferring the multilayer material into sintering equipment, and carrying out high-temperature calcination in the argon atmosphere to transform the composite material layer into a positive active material layer through a high-temperature solid-phase reaction;
(5) carrying out magnetron sputtering on the material subjected to the high-temperature calcination by using an aluminum target, to sputter and deposit an aluminum current collector layer on a surface of the positive active material layer;
(6) uniformly dropwise coating a surface of the LiPON thin film layer with molten metal lithium under an argon protection atmosphere, applying a pressure after cooling to flatten a metal lithium layer, and compressing a battery core; and
(7) packaging the battery core in a battery shell to obtain the lithium secondary battery.

2. The preparation method according to claim 1, wherein a purity of the target material used is greater than or equal to 99.9%.

3. The preparation method according to claim 1, wherein the sulfide solid electrolyte in step (1) is one or more of Li₂S-P₂S₅, Li₁₀GeP₂S₁₂, Li₇P₂S₈X, and Li₆PS₅X, and X is one or more of Cl, Br, and I; and the sulfide solid electrolyte layer is prepared by tabletting sulfide solid electrolyte powder.

4. The preparation method according to claim 1, wherein the LiPON thin film layer in step (1) has a thickness of 5 to 10 □m.

5. The preparation method according to claim 1, wherein the Li₃PO₄ thin film layer in step (2) has a thickness of 0.1 to 1 □m.

6. The preparation method according to claim 1, wherein the composite material layer in step (3) has a thickness of 5 to 10 □□m.

7. The preparation method according to claim 1, wherein the high-temperature calcination in step (4) is two-stage sintering; in the first stage of sintering, a heating rate is 3 to 5 °C/min, a sintering temperature is 350 to 450°C, and the temperature is kept for 3 to 6 h; and in the second stage of sintering, a heating rate is 5 to 10 °C/min, a sintering temperature is 650 to 900°C, and the temperature is kept for 6 to 18 h.

8. The preparation method according to claim 1, wherein the aluminum current collector layer in step (5) has a thickness of 1 to 10 □m.

9. The preparation method according to claim 1, wherein the metal lithium layer in step (6) has a thickness of 1 to 5 □m; and the applying a pressure is performed by applying a pressure of 5 to 10 MPa to one side of the metal lithium layer using a polyimide plate.

10. A lithium secondary battery, wherein the lithium secondary battery is prepared by the preparation method according to any one of claims 1 to 9.
